# EUROPEAN PATENT APPLICATION

(11) **EP 2 685 795 A1**
(43) Date of publication of application: **15.01.2014**
(21) Application number: 12754301.5
(22) Date of filing: 27.02.2012
(51) Int. Cl.: H05K 1/14, H05K 1/02, H05K 3/00

(54) **CIRCUIT BOARD AND METHOD FOR MANUFACTURING CIRCUIT BOARD**

(30) Priority: 09.03.2011 JP 2011051166
(71) Applicant: Furukawa Electric Co., Ltd., Chiyoda-ku Tokyo 100-8322 (JP); Furukawa Automotive Systems Inc., Inukami-gun, Shiga 522-0242 (JP)
(72) Inventor: ABE, Kyutaro, Tokyo 100-8322 (JP); FUKAI, Hiroyuki, Tokyo 100-8322 (JP); KIHARA, Yasushi, Tokyo 100-8322 (JP); UTSUMI, Juro, Tokyo 100-8322 (JP); TAKAHASHI, Naomi, Tokyo 100-8322 (JP)
(74) Representative: Horn Kleimann Waitzhofer
(86) International application number: PCT/JP2012/054711
(87) International publication number: WO 2012/121036

(57) **Abstract**

A circuit board (1) is formed such that a printed circuit board (5) is connected to an injection molded circuit board (3). An internal circuit conductor is exposed at conductor part (15b) at a printed circuit board mounting part (11). Through holes (21) are provided in the printed circuit board (5). The conductor part (15b) is formed substantially perpendicular to the circuit board mounting part (11), and is inserted into a through hole (21). A female screw part (17) is formed in the vicinity of the conductor part (15b) in the printed circuit board mounting part (11). The female screw part (17) can be screwed together with a bolt (23), which is a securing member. The printed circuit board (5) is connected to the conductor part (15b) by solder (25). A hole (19) is formed in advance in the vicinity of the solder (5) on the printed circuit board (5). The bolt (23) passes through the hole (19) and is secured to the female screw part (17).

## Description

### FIELD OF THE INVENTION

This invention relates to a circuit board comprising an injection molded circuit board equipped with a high current circuit such as a DC-DC converter, an inverter etc., used for cars, household appliances, industrial machineries or the like and a printed circuit board for a low current used as a control circuit connected to the injection molded circuit board.

### BACKGROUND OF THE INVENTION

Conventionally, an injection molded circuit board equipped with a high current circuit used for cars, household appliances, industrial machineries or the like are used together with a printed circuit board, connected thereto, on which a control circuit for controlling them is equipped. The injection molded circuit board is electrically connected to the printed circuit board through jumper connection by wiring, bus bar soldering connection, connector connection or the like. Various efforts for simplifying and downsizing them have been made.

Such a circuit board can be formed through a procedure in which a metal conductor of the high current circuit is slashed, is bent upright and is connected to the control circuit by soldering, for example. (See Patent Document 1)

### PRIOR ART DOCUMENT

### PATENT DOCUMENT

Patent Document 1
   Japanese Unexamined Patent Application Publication No. H14-134870 (JP-A-H14-134870)

### SUMMARY OF THE INVENTION

### PROBLEMS TO BE SOLVED BY THE INVENTION

However, in Patent Document 1, electric connection reliability for soldering is not described. In fact, resin material differs between the high current circuit board and the low current printed circuit board, and the linear expansion coefficients also differ between them, and an excessive load may be applied to the solder part because of the difference in the degree of extension and contraction between them at the time of temperature change.

The present invention was achieved in view of such problems. Its object is to provide a circuit board which can be used for high current devices such as a DC-DC converter on which small electronic part can be placed and which is excellent in reliability for electric connections thereon, and also to provide a method for manufacturing the circuit board.

### MEANS TO SOLVE THE PROBLEMS

To achieve the above object, the first invention is a circuit board comprising: an injection molded circuit board in which a resin is injection molded on the surface of a circuit conductor; and a printed circuit board equipped with electronic parts in advance on the surface thereof, wherein: a part of the circuit conductor is exposed from the injection molded circuit board; a part of the exposed circuit conductor is electrically connected to the printed circuit board by solder; and in the vicinity of the solder part, the printed circuit board is fixed on the injection molded circuit board by a securing member.

The securing member is a bolt; a female screw part is formed in advance in the resin part of the injection molded circuit board; and the printed circuit board may be fixed by the bolt secured to the female screw part.

It is desirable that the part of the circuit conductor exposed from the injection molded circuit board penetrates a through hole formed in the printed circuit board and is electrically connected to the printed circuit board by solder.

When the diameter of the securing member is set to D (mm) and diameter of an electric junctional solder part is set to d (mm), it is desirable that the distance between the center of the solder part and the center of the securing member is equal to or less than (D + d)/2 + 9 (mm).

In the injection molded circuit board, at least a pair of convex parts is formed; the printed circuit board is placed on the convex parts; and a bolt which is the securing member may be secured to a female screw part formed in the convex parts. The circuit conductor is exposed on the convex part; and the exposed circuit conductor part penetrates a through hole in the printed circuit board placed on the convex parts and may be electrically connected to the printed circuit board by solder.

A space is formed between the injection molded circuit board and the printed circuit board, and electronic parts may be installed in the space on the injection molded circuit board.

A stress relaxation part may be formed in the part of the circuit conductor exposed from the injection molded circuit board, and the stress relaxation part is configured from the circuit conductor which is bent so that a horizontal part and a vertical part are contained at least in a section.

A stress relaxation part may be formed in the part of the circuit conductor exposed from the injection molded circuit board, and the stress relaxation part may be a lower stiffness part formed in a section of the circuit conductor.

According to the first invention, since the injection molded circuit board comprising, for example, a pressed circuit conductor and a resin formed by injection molding is used for the circuit board, the circuit conductor can be thick. Thereby, a circuit board that tolerates high current can be obtained. On the injection molded circuit board, a printed circuit board mounting part for mounting the printed circuit board is formed in addition to an electronic parts mounting part for mounting electronic parts. Thereby, the printed circuit board, on which small electronic parts have been placed in advance separately, can also be mounted on the same circuit board.

The printed circuit board and the injection molded circuit board are connected by solder, and also are fixed together by the securing member in the vicinity of the solder part. Thereby, generation of stress at the solder part accompanying temperature change due to the difference in linear expansion coefficients between the material of the injection molded circuit board and that of the printed circuit board, is eased. A female screw part in the resin part of the injection molded circuit board assists the bolt, which is a securing member, to be fixed easily.

Also, the part of the circuit conductor exposed from the injection molded circuit board is made to penetrate a through hole formed in the printed circuit board and is electrically connected to the printed circuit board by solder, and the solder part is formed on the printed circuit board. Thereby, the solder part can be checked easily.

Diameter of the securing member is set to D (mm) and diameter of an electric junctional solder part is set to d (mm). Then, when the distance between the center of the solder part and the center of the securing member is equal to or less than (D + d)/2 + 9 (mm), generation of superfluous stress at the solder part can certainly be prevented.

If at least a pair of convex parts is formed in the injection molded circuit board, and the printed circuit board is placed on the convex parts, and the bolt which is the securing member is secured to the female screw part formed in the convex parts, then the solder part on the printed circuit board and the bolt is placed on the same convex part. Thereby, the stress generated at the solder part can certainly be eased. Also, when a space is formed between the injection molded circuit board and the printed circuit board and electronic parts are installed in the space on the injection molded circuit board, the electronic parts can be arranged in a layer structure. Therefore, downsizing of the circuit board can be attained.

If a stress relaxation part is formed in the part of the circuit conductor exposed from the injection molded circuit board, displacement accompanying thermal expansion between the injection molded circuit board and the printed circuit board can be eased at the stress relaxation part. Thereby, the stress directly generated at the solder part can be suppressed. Here, since a stress relaxation part is configured from the circuit conductor which is bent so that at least a horizontal part and a vertical part are contained in a section, it can certainly ease the stress in both the horizontal and the vertical directions.

If a lower stiffness part is formed as the stress relaxation part in a section of the circuit conductor, the lower stiffness part can easily be deformed and the stress can certainly be eased.

The second invention is a method for manufacturing a circuit board comprising the steps of: forming a circuit conductor by joining electrically conductive circuit materials; forming an injection molded circuit board by carrying out injection molding of a resin on the surface of the circuit conductor; installing a printed circuit board in a way that a part of the circuit conductor exposed from the upper surface of the injection molded circuit board penetrates a through hole in the printed circuit board; electrically connecting the circuit conductor to the printed circuit board and electronic parts by solder; and fixing the printed circuit board onto the injection molded circuit board by a bolt using a female screw part formed in advance in a resin part of the injection molded circuit board.

According to the second invention, the circuit board can tolerate high current; small electronic parts can also be placed on the same circuit board; and superfluous stress is never generated at the solder part, which is junction between the injection molded circuit board and the printed circuit board.

### EFFECTS OF THE INVENTION

According to the present invention, a circuit board which can be used for high current such as a DC-DC converter, on which small electronic parts can also be placed, and which has excellent reliability in its electric junctions, and a method for manufacturing the circuit board can be provided.

### BRIEF DESCRIPTION OF THE DRAWINGS

Figs. 1 are perspective views showing a circuit board 1. Fig. 1(a) is its exploded perspective view and Fig. 1(b) is its assembled perspective view.
Fig. 2 is a cross-sectional view of the circuit board 1 at the A-A line shown in the Fig. 1(b).
Fig. 3 is an enlarged view of the part B in Fig. 2.
Fig. 4 shows a relation between the distance from a bolt to the solder part and the stress generated at the solder part.
Fig. 5 is a cross-sectional view of a circuit board 30, for showing a modification of the printed circuit board.
Figs. 6 are cross-sectional views for showing modifications of the printed circuit board. Fig. 6(a) shows a printed circuit board 40a and Fig.6 (b) shows a printed circuit board 40b.
Fig. 7 is a cross-sectional view of a circuit board 50 for showing a modification of the printed circuit board.

### DETAILED DESCRIPTION OF THE PREFERRED EMBODIMENTS

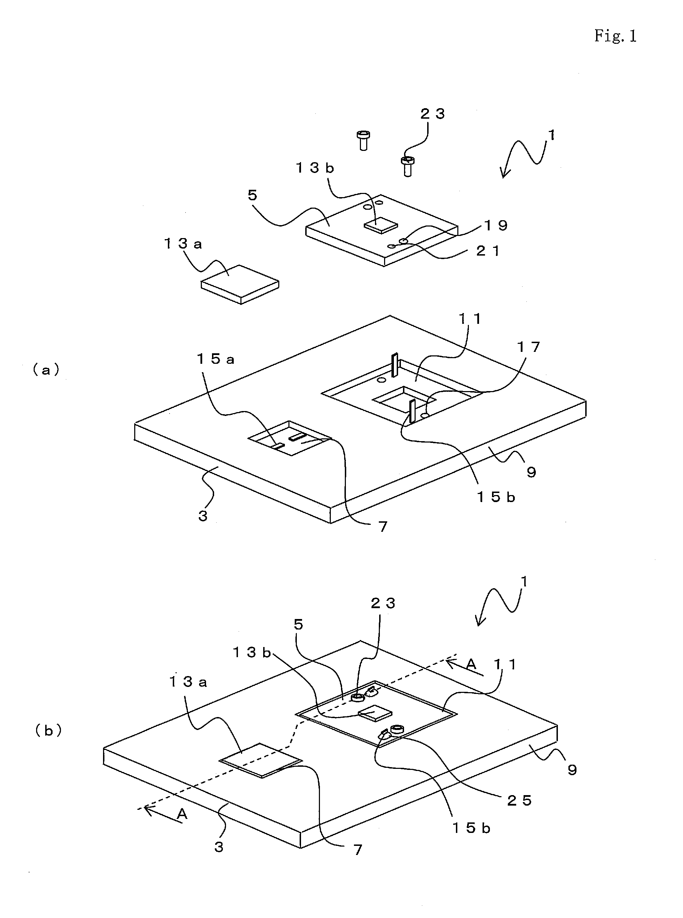

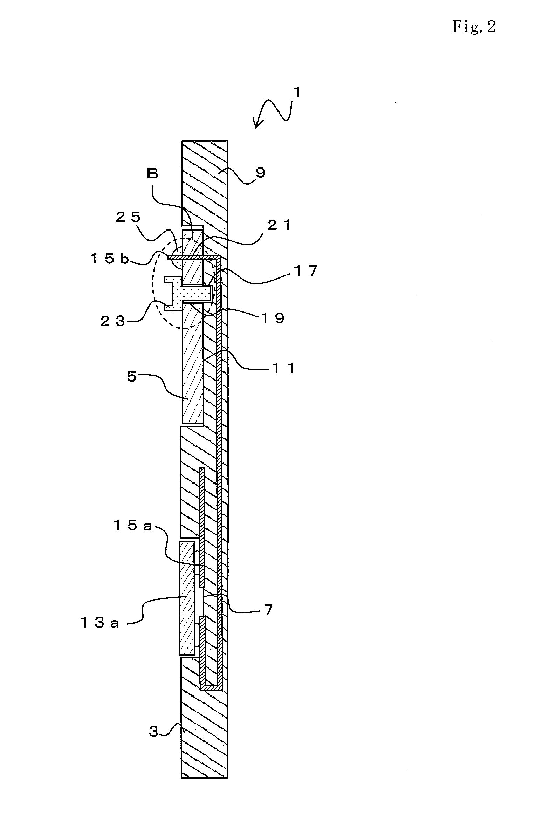

Hereinafter, embodiments of the present invention will be described referring to the drawings. Figs. 1 and Fig. 2 show a circuit board 1. Fig. 1(a) is an exploded perspective view of the circuit board 1 and Fig. 1(b) is its assembled perspective view. Fig. 2 is a cross-sectional view of the circuit board 1 at the A-A line shown in Fig. 1(b). The circuit board 1 can be used for high current.

The circuit board 1 is formed through a procedure in which a printed circuit board 5 is connected to an injection molded circuit board 3. In the injection molded circuit board 3, an electronic parts mounting part 7 and a printed circuit board mounting part 11 are formed. In the electronic parts mounting part 7 and the printed circuit board mounting part 11, internal circuit conductor is exposed at conductor parts 15a and 15b, respectively. Other parts of circuit conductor than the conductor parts are covered with a resin 9.

For formation of the printed circuit board 5, a conventional glass epoxy board is used. Electronic parts 13b are mounted in advance on the printed circuit board 5.

The electronic parts mounting part 7 is a part where the electronic parts 13a are mounted, and the printed circuit board mounting part 11 is a part where the printed circuit board 5 is mounted. Through holes 21 are provided in the printed circuit board 5. The through holes 21 are plated for layer to layer connection. The conductor parts 15b are formed approximately perpendicular to the printed circuit board mounting part 11 and are inserted into the through holes 21.

Female screw parts 17 are formed in the vicinity of the conductor parts 15b in the printed circuit board mounting part 11. The female screw parts 17 can be screwed together with bolts 23 which are securing members. Electronic parts 13a are connected to the conductor parts 15a in the electronic parts mounting part 7 by solder etc. The printed circuit board 5 is connected to the conductor parts 15b at the parts projected out from the upper surface of the printed circuit board 5 after penetrating the through holes 21, by solder parts 25. Holes 19 are formed in advance in the vicinity of the solder parts 25 (the through holes 21) in the printed circuit board 5. The bolts 23 penetrate the holes 19 and are secured to the female screw parts 17.

The circuit board of the present invention is not limited to the circuit board having the shape shown in the drawings. The circuit board of the present invention can naturally be applied to the circuit boards for high current such as a DC-DC converter having transformers and choke coils. It is needless to say that the present invention is not limited to the arrangements of the parts and the shapes shown in the drawings, and that other parts etc. can be properly mounted and the arrangements and the shapes can suitably be changed.

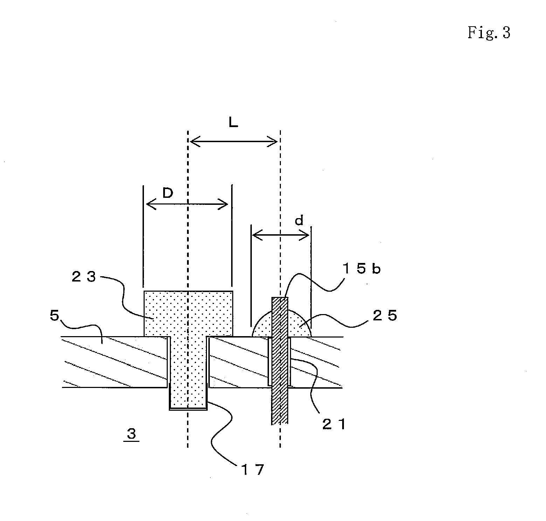

Fig. 3 is an enlarged view of the part B shown in Fig.2. Distance between the center line of the bolt 23 and the center of the solder part 25 (the through hole 21) is set to L. The diameter of the head of the bolt 23 is set to D (mm) and the diameter of the electric junctional solder part 25 (the diameter of the conductor pad on the through hole 21) is set to d (mm).

Then, it is desirable that L is equal to or more than (D + d)/2 + 1 (mm) and equal to or less than (D + d)/2 + 9 (mm). If L is equal to or more than (D + d)/2 + 1 (mm), the securing member and the solder part do not interfere each other. If L exceeds (D + d)/2 + 9 (mm), stress generated at the solder part increases rapidly. Therefore, if L is set to equal to or less than (D + d)/2 + 9 (mm), stress generated at the solder part 25 due to the difference in the thermal expansion coefficients of respective resins forming the injection molded circuit board 3 and the printed circuit board 5 can be reduced.

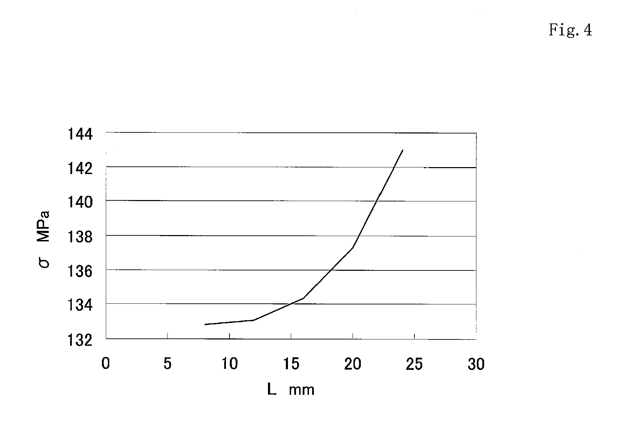

Fig. 4 shows an analysis of the relation between the distance L from the center of the bolt 23 to the center of the solder part 25 and the stress σ generated at the solder part 25. When the diameter of the head of the bolt was set to 10mm and the diameter of the conductor pad on the through hole was set to 4mm and the distance L between the centers was changed, the maximum stress generated at the solder part 25 was analyzed by FEM. The thermal expansion coefficient of the printed circuit board was set to 15ppm/°C (corresponding to glass epoxy board FR-4) and the thermal expansion coefficient of the injection molded circuit board was set to 40ppm/°C (corresponding to polyphenylene sulfide), and the maximum stress was calculated when temperature was changed from -40°C to 120°C.

As is clear from Fig. 4, the stress increases rapidly when L exceeds 16 mm. Therefore, it is desirable that L is set to equal to or less than 16 mm in this invention. That is, if the diameter of the head of the bolt 23 is set to D (mm) and the diameter of the conductor pad on the through hole 21 is set to d (mm), it is desirable that L is (D + d)/2 + 9 mm.

The circuit board 1 is manufactured, for example, as follows. First, a circuit material, which is a conductor such as a copper plate, is punched out by a press machine, and is subjected to required bending processes to be formed into a desired shape. Sn plating etc. may be performed to the copper plate, etc. if needed. Subsequently, a plurality of circuit materials are joined together by welding or joined together through intermediary of an insulating member etc. to be formed into a circuit conductor. The circuit conductor may be formed not only in a plane but also in a plurality of layers.

The obtained circuit conductor is fixed to a prescribed position in an injection mold by pins etc., and a resin is ejected. In this way, the injection-molding is performed. On this occasion, the circuit conductor except for the required exposed conductor parts is covered with the resin 9, and the resin is also injected between the layers of the circuit materials. In this way, the injection molded circuit board 3 is formed. Metal nuts etc. which form the female screw parts may be installed in advance and may be unified by the resin at the moment of injection.

The resin 9 has only to be insulating and be capable of being injection molded, and for example, liquid crystal polymer, polyphenylene sulfide, polybutylene terephthalate, polyether sulfone, polyether ether ketone, polyphthalamide etc. can be used as the resin 9.

As a conductor circuit material, a copper plate or the like equal to or more than 400 µm thick is used, for example. This is because the conductor circuit material less than 400 µm thick is hard to tolerate high current and may be deformed by resin pressure at the moment of injection molding. The thickness of the conductor circuit material is more desirably to be 400 µm to 1000 µm. If the conductor circuit material is too thick, cost and weight etc. may increase, and a compact circuit board cannot be formed.

Next, the electronic parts 13a are mounted on the electronic parts mounting part 7 and electrodes of the electronic parts are electrically connected to the conductor parts 15a etc. Similarly, the printed circuit board 5 is mounted on the printed circuit board mounting part 11 and the conductor parts 15b are inserted into the through holes 21 of the printed circuit board 5 and are connected together electrically. Solder, wire bonding etc. are used for each electrical connection. Finally, the printed circuit board 5 is fixed by the bolts 23.

Mounting of parts on the printed circuit board 5 may be carried out by the procedures in which creamy solder is printed at prescribed positions and parts such as small capacitors are mounted on the prescribed positions, and then the parts are bonded by passing the printed circuit board 5 through a reflow furnace where the solder is melt.

As explained above, according to the circuit board 1 of the present embodiment, a thick copper circuit board can be formed since the circuit material is processed by the press machine, and the resin 9 is processed by injection molding, and thus the circuit board 1 having excellent manufacturability and having tolerance to high current can be obtained. In the circuit board 1 formed in this way, low current of the signaling system can utilize circuits on the printed circuit board 5 (small capacitors etc.) and the high current of the power system can utilize the circuit conductor of the injection molded circuit board. Since all these circuits can be mounted on one circuit board, connections by cables etc. among circuit boards become unnecessary, and the cost reduction and downsizing can be attained.

Moreover, since the printed circuit board 5 and the injection molded circuit board 3 are connected by the solder parts 25 and are fixed together by the bolts 23 in the vicinity of the solder parts 25, superfluous stress is not generated at the solder parts 25.

In addition, since the conductor parts 15b are connected by the solder parts 25 after penetrating the through holes 21, the solder parts can be easily recognized visually.

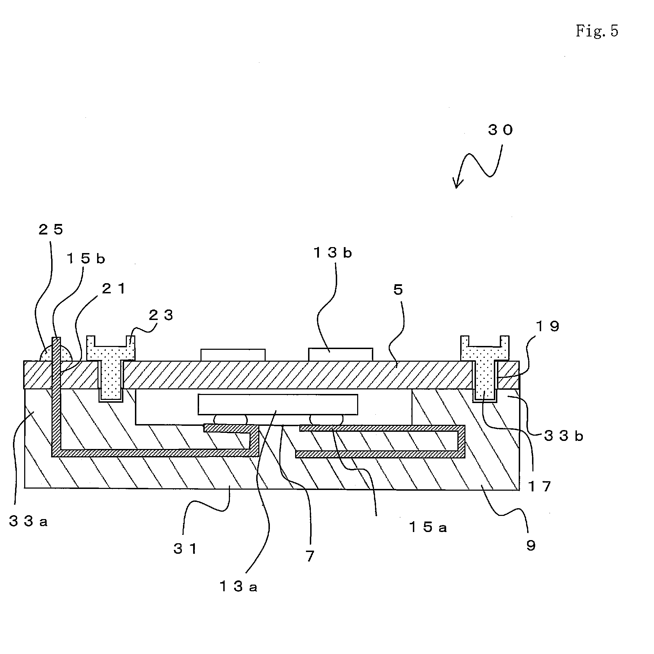

Next, the second embodiment is described. Fig. 5 shows a circuit board 30 according to the second embodiment. In the following explanation, on the components which perform the same function as in the circuit board 1, the same numerals as in Fig. 1 are attached and the overlapping explanations are omitted.

The circuit board 30 has approximately the same composition as the circuit board 1, but the modes of an injection molded circuit board 31 etc. differ. A pair of convex parts 33a and 33b is formed in the injection molded circuit board 31. The convex parts 33a and 33b function as the printed circuit board mounting part in the injection molded circuit board 31.

The conductor parts 15b exposed from the injection molded circuit board 31 expose on the upper surface of the convex parts 33a and 33b. The printed circuit board 5 is installed so that it straddles at least a pair of convex parts 33a and 33b. The conductor parts 15b penetrate the through holes 21 of the printed circuit board 5 and then are electrically connected to the printed circuit board 5 by the solder parts 25.

The female screw part 17 is provided in the convex part 33b. Therefore, the printed circuit board 5 is fixed to the injection molded circuit board 31 by the bolt 23 on the convex part 33b. The female screw part 17 and the conductor part 15b are exposed on the convex part 33a. The through hole 21 of the printed circuit board 5 is allocated on the convex part 33a. Therefore, the printed circuit board 5 is electrically connected to the conductor part 15b and also is fixed to the injection molded circuit board 31 by the bolt 23 on the convex part 33a. The female screw parts 17 and the conductor parts 15b may be exposed on both of the convex parts 33a and 33b. In the following explanation, the convex parts 33a and 33b together are called the convex parts 33.

In the circuit board 30, a space is formed between the printed circuit board 5 and the injection molded circuit board 31 in a region sandwiched by the convex parts 33. The electronic parts 13a to be mounted on the injection molded circuit board 31 may be placed in this space. Hence, the electronic parts mounting part 7 is formed between the convex parts 33.

According to the second embodiment, the same effect as the first embodiment can be obtained. In addition, a small circuit board can be obtained since the electronic parts to be mounted on the injection molded circuit board and the electronic parts to be mounted on the printed circuit board can be placed in layers.

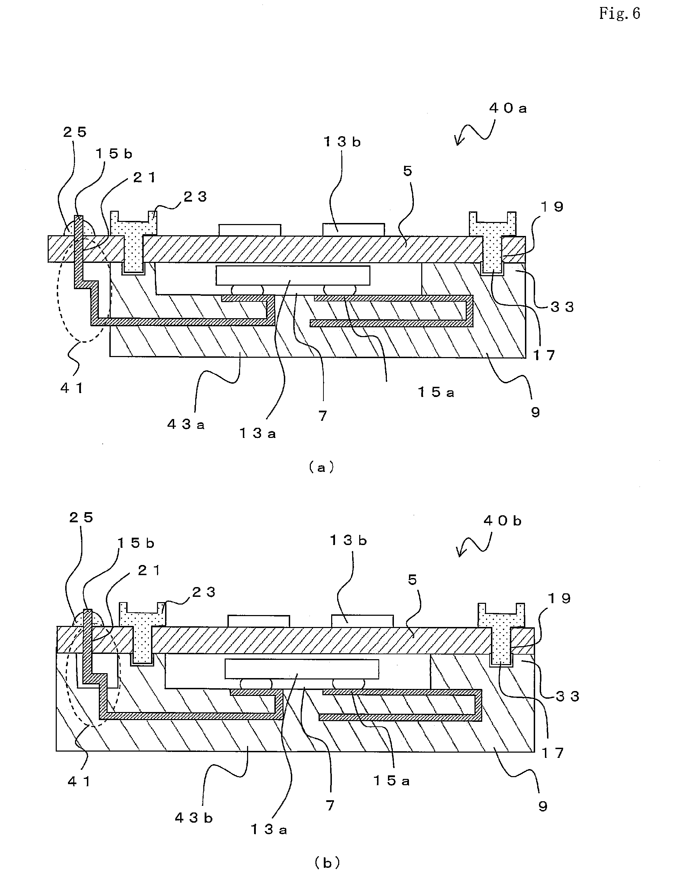

Next, the third embodiment is described. Fig. 6 (a) shows a circuit board 40a according to the third embodiment. In the circuit board 40a, stress relaxation parts 41 are further formed compared to the circuit board 30.

In the circuit board 40a, the conductor parts 15b which are to be connected to the printed circuit board 5 do not penetrate the printed circuit board 5 straight from the surface of the resin 9. The conductor parts 15b are configured to project out in approximately horizontal direction (approximately parallel to the surface of the circuit board) from the side surface of an injection molded circuit board 43a and further to be bent upward. It is desirable that horizontal and vertical parts are formed at least in a section of the bent parts.

The bent parts in the conductor parts 15b function as the stress relaxation parts 41. The conductor parts 15b are not restrained at the stress relaxation parts 41 and some of their sections can be deformed in accordance with the deformation due to the thermal expansion difference between the printed circuit board 5 and the injection molded circuit board 43a. Thereby, the stress relaxation parts 41 can suppress generation of stress at the solder parts 25.

If at least two sections in the horizontal direction and in the vertical direction are formed in the stress relaxation part 41, the stress generated at the solder part in the horizontal and vertical directions can be eased easily.

The composition of the stress relaxation part 41 is not limited to the example of Fig. 6 (a). It is not necessary that the stress relaxation part 41 is exposed from a side surface of the injection molded circuit board 43b, as is shown in the circuit board 40b in Fig. 6 (b), for example. Namely, the stress relaxation part 41 has only to be a section of the conductor part 15b not restrained and deformable, located between the junction with the printed circuit board 5 and the point where the conductor part 15b starts to be exposed from the surface of the injection molded circuit board.

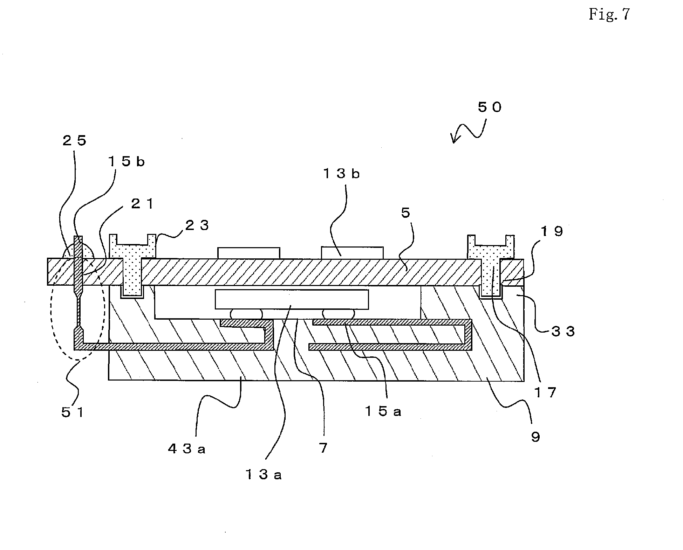

Fig. 7 further shows an example of modification of the stress relaxation part. The circuit board 50 shown in Fig. 7 has approximately the same composition as the circuit board 40a, but a small diameter part is formed instead of the bent parts in the conductor part 15b. Namely, a lower stiffness part is provided in the non-restrained part of the conductor part 15b. The lower stiffness part is more deformable than other parts. Thereby, the stress relaxation part deforms easily corresponding to the displacement between the printed circuit board and the injection molded circuit board described above, and thus the stress generated at the solder part 25 can be eased.

According to the third embodiment, the same effect as the first embodiment can be obtained. Also, since a part of the conductor part 15b which connects the printed circuit board to the injection molded circuit board is exposed from the resin of the injection molded circuit board to form the stress relaxation part, the stress generated at the solder part 25 can be eased.

The embodiments of the present invention have been explained referring to the attached drawings, but the technical scope of the present invention is not limited by the embodiments described above. It is clear that persons skilled in the art can think out various examples of changes or modifications within the scope of the technical idea disclosed in the claims, and it will be understood that they naturally belong to the technical scope of the present invention.

For example, each of the compositions described above can naturally be combined with one another. Through holes do not have to be used for connection between the printed circuit board and the injection molded circuit board. In addition, the printed circuit board and the injection molded circuit board may be fixed using securing members such as pins which can fix them mechanically, instead of the bolts.

### EXPLANATION OF NUMERALS

1, 30, 40a, 40b, 50....... circuit board
3....... injection molded circuit board
5....... printed circuit board
7....... electronic parts mounting part
9....... resin
11...... printed circuit board mounting part
13a, 13b.....electronic parts
15a, 15b.....conductor part
17..... female screw part
19..... hole
21..... through hole
23..... bolt
25..... solder part
31..... injection molded circuit board
33a, 33b..... convex part
41, 51........ stress relaxation part
43a, 43b..... injection molded circuit board

## Claims

1. A circuit board comprising:
an injection molded circuit board in which a resin is injection molded on the surface of a circuit conductor; and
a printed circuit board equipped with electronic parts in advance on the surface thereof, wherein:
a part of the circuit conductor is exposed from the injection molded circuit board;
a part of the exposed circuit conductor is electrically connected to the printed circuit board by solder; and
in the vicinity of the solder part, the printed circuit board is fixed on the injection molded circuit board by a securing member.

2. The circuit board according to claim 1, wherein:
the securing member is a bolt;
a female screw part is formed in advance in the resin part of the injection molded circuit board; and
the printed circuit board is fixed by the bolt secured to the female screw part.

3. The circuit board according to claim 1, wherein:
the part of the circuit conductor exposed from the injection molded circuit board penetrates a through hole formed in the printed circuit board and is electrically connected to the printed circuit board by solder.

4. The circuit board according to claim 1, wherein:
when diameter of the securing member is set to D (mm) and diameter of an electric junctional solder part is set to d (mm), the distance between the center of the solder part and the center of the securing member is equal to or less than (D + d)/2 + 9 (mm).

5. The circuit board according to claim 1, wherein:
at least a pair of convex parts is formed in the injection molded circuit board;
the printed circuit board is placed on the convex parts; and
a bolt which is the securing member is secured to a female screw part formed in the convex parts.

6. The circuit board according to claim 5, wherein:
the circuit conductor is exposed on the convex parts; and
the exposed circuit conductor part penetrates a through hole in the printed circuit board placed on the convex parts, and is electrically connected to the printed circuit board by solder.

7. The circuit board according to claim 5, wherein:
a space is formed between the injection molded circuit board and the printed circuit board; and
electronic parts are installed in the space on the injection molded circuit board.

8. The circuit board according to claim 1, wherein:
a stress relaxation part is formed in the part of the circuit conductor exposed from the injection molded circuit board, and the stress relaxation part is configured from the circuit conductor which is bent so that a horizontal part and a vertical part are contained at least in a section.

9. The circuit board according to claim 1, wherein:
a stress relaxation part is formed in the part of the circuit conductor exposed from the injection molded circuit board, and the stress relaxation part is a lower stiffness part formed in a section of the circuit conductor.

10. A method for manufacturing a circuit board, comprising the steps of:
forming a circuit conductor by joining electrically conductive circuit materials;
forming an injection molded circuit board by carrying out injection molding of a resin on the surface of the circuit conductor;
installing a printed circuit board in a way that a part of the circuit conductor exposed from the upper surface of the injection molded circuit board penetrates a through hole in the printed circuit board;
electrically connecting the circuit conductor to the printed circuit board and electronic parts by solder; and
fixing the printed circuit board onto the injection molded circuit board by a bolt using a female screw part formed in advance in a resin part of the injection molded circuit board.
